# EUROPEAN PATENT APPLICATION

(11) **EP 4 601 197 A1**
(43) Date of publication of application: **13.08.2025**
(21) Application number: 24382128.7
(22) Date of filing: 09.02.2024
(51) Int. Cl.: H03K 17/96

(54) **CAPACITIVE TOUCH SENSOR CIRCUIT**

(71) Applicant: E.G.O. Elektro-Gerätebau GmbH, 75038 Oberderdingen (DE)
(72) Inventor: Manan, Jose, 08185 Lliçà de Vall (Barcelona) (ES); Pérez, Víctor, Newnan, 30263 (US)
(74) Representative: Patentanwälte Ruff, Wilhelm, Beier, Dauster & Partner mbB

(57) **Abstract**

Capacitive touch sensor circuit (100), comprising:
- a capacitive sensor element (1), wherein a capacitance of the capacitive sensor element (1) depends on the actuation state of the capacitive sensor element (1),
- an accumulation capacitor (2),
- a charging voltage source (3) being configured to generate a charging voltage (VC) for charging the capacitive sensor element (1),
- a charge transfer transistor (4) being configured to transfer electrical charge from the charged capacitive sensor element (1) to the accumulation capacitor (2), and
- an actuation detection device (5) being configured to measure a voltage (VA) across the accumulation capacitor (2) to detect if the capacitive sensor element (1) is actuated or not actuated,
- wherein the charging voltage source (3) is configured to generate a saw-tooth-formed charging voltage (VC) for charging the capacitive sensor element (1).

## Description

The invention is based on the object to provide for a capacitive touch sensor circuit being highly reliable and cost effective to manufacture.

The capacitive touch sensor circuit comprises: a capacitive sensor element, wherein a capacitance of the capacitive sensor element depends on the actuation state of the capacitive sensor element, an accumulation capacitor, a charging voltage source being configured to generate a charging voltage for charging the capacitive sensor element, a charge transfer transistor being configured to transfer electrical charge from the charged capacitive sensor element to the accumulation capacitor, and an actuation detection device being configured to measure a voltage across the accumulation capacitor to detect if the capacitive sensor element is actuated or not actuated. The charging voltage source is configured to generate a saw-tooth-formed charging voltage for charging the capacitive sensor element.

According to an embodiment the charge transfer transistor, i.e. its switching state, is controlled by the charging voltage.

According to an embodiment the saw-tooth-formed charging voltage repeatedly is formed by: a, in particular linear, rising slope having a duration between 0,001 ms and 10 ms, wherein a voltage difference between the start of the rising slope and the end of the rising slope is in a range between 3 V and 48 V, a plateau having a duration between 0,001 ms and 1 ms, and a falling slope having a duration between 1 ns and 10 µs.

According to an embodiment the capacitive touch sensor circuit comprises: a first diode connected between the charging voltage and the emitter of the charge transfer transistor, wherein the capacitive sensor element is connected between the emitter of the charge transfer transistor and a reference potential, in particular ground, a first resistor, wherein the first resistor is connected in parallel to the capacitive sensor element, a second diode, wherein the second diode is connected between the collector of the charge transfer transistor and the accumulation capacitor, and wherein the accumulation capacitor is connected between the cathode of the second diode and the reference potential.

According to an embodiment the capacitive touch sensor circuit comprises: a second resistor, wherein the second resistor is connected in parallel to the accumulation capacitor, and a third resistor, wherein the third resistor is connected between the charging voltage and the base of the charge transfer transistor.

According to an embodiment the first diode and the second diode are Schottky diodes.

According to an embodiment the charging voltage source comprises: a ramp capacitor, wherein the potential difference across the ramp capacitor corresponds to the charging voltage, a current source supplying a, in particular constant, charging current to the ramp capacitor, and a discharging circuit periodically discharging the ramp capacitor.

According to an embodiment a capacitance of the accumulation capacitor is significantly larger, in particular at least 100 times larger, than a capacitance of the capacitive sensor element.

The capacitive sensor element may e.g. be embodied as a so-called Touch-On-Metal button. A capacitance of the capacitive sensor element changes by e.g. pressing a pre-defined zone assigned in a user Interface. The change of the capacitance is detected by means of the inventive capacitive touch sensor circuit without needing a specialized IC. According to the invention, only 3 transistors, 2 Schottky diodes and 2 ordinary diodes as semiconductors and additional passive components are needed. Since the capacitive touch sensor circuit is based on discrete components, the cost is reduced significantly. According to the invention, a voltage change as a function of the capacitance change is used as the functional basis.

According to the invention, an electric charge increment, as the result of pressing a metallic predefined zone with a finger, is transferred and stored in the accumulating capacitor at a specific repetition rate. Actuation is reflected as a voltage change that is processed to detect the presence of the finger in the predefined zone. Few hundreds of millivolts can be detected using a PNP-transistor during the transition of a cutoff state to forward biased.

The invention will now be described in detail with respect to the drawings. In the drawings,
- Fig. 1: depicts a circuit diagram of an inventive capacitive touch sensor circuit and
- Fig. 2: depicts signals of the capacitive touch sensor circuit of Fig. 1.

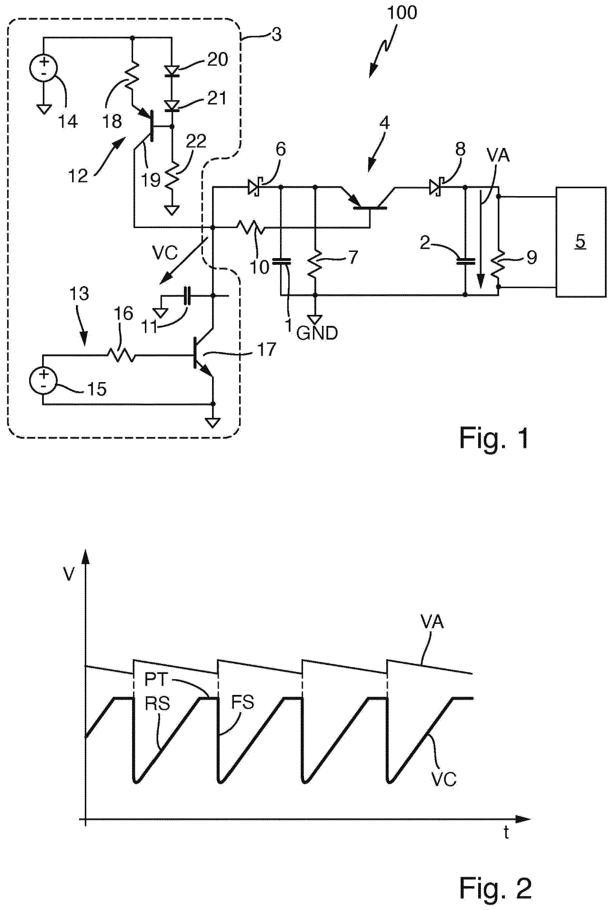

Fig. 1 depicts a circuit diagram of an inventive capacitive touch sensor circuit 100, comprising: a capacitive sensor element 1, e.g. in form of a Touch-On-Metal button, wherein a capacitance of the capacitive sensor element 1 depends on the actuation state, e.g. pressed or not pressed, of the capacitive sensor element 1, an accumulation capacitor 2, a charging voltage source 3 being configured to generate a charging voltage VC for charging the capacitive sensor element 1, a bipolar PNP charge transfer transistor 4 being configured to transfer electrical charge from the charged capacitive sensor element 1 to the accumulation capacitor 2, and an actuation detection device 5 being configured to measure a voltage VA across the accumulation capacitor 2 to detect if the capacitive sensor element 1 is actuated or not actuated.

Typically, an actuation of the capacitive sensor element 1 causes an increase in the voltage VA across the accumulation capacitor 2.

The capacitive touch sensor circuit 100 comprises a first diode 6 connected between the charging voltage VC and the emitter of the charge transfer transistor 4. The capacitive sensor element 1 is connected between the emitter of the charge transfer transistor 4 and a reference potential Ground GND.

The capacitive touch sensor circuit 100 further comprises a first resistor 7, wherein the first resistor 7 is connected in parallel to the capacitive sensor element 1, a second diode 8, wherein the second diode 8 is connected between the collector of the charge transfer transistor 4 and the accumulation capacitor 2, and wherein the accumulation capacitor 2 is connected between the cathode of the second diode 8 and the reference potential GND.

The capacitive touch sensor circuit 100 further comprises a second resistor 9, wherein the second resistor 9 is connected in parallel to the accumulation capacitor 2, and a third resistor 10, wherein the third resistor 10 is connected between the charging voltage VC and the base of the charge transfer transistor 4.

The first diode 6 and the second diode 8 are Schottky diodes.

The charging voltage source 3 comprises: a ramp capacitor 11, wherein the potential difference across the ramp capacitor 11 corresponds to the charging voltage VC, a current source 12 supplying a constant charging current to the ramp capacitor 11, and a discharging circuit 13 periodically discharging the ramp capacitor 11.

The current source 12 comprises a constant voltage source 14, resistors 18 and 22, a transistor 19 and diodes 20 and 21 interconnected in the depicted topology.

The discharging circuit 13 comprises a voltage source 15 generating a pulse shaped voltage, a resistor 16 and a transistor 17 being controlled by the pulse shaped voltage generated by the voltage source 15. The transistor 17, depending on the pulse shaped voltage, connects a terminal of the ramp capacitor 11 to the reference potential GND to discharge the ramp capacitor 11 or disconnects the terminal of the ramp capacitor 11 from the reference potential GND while charging the ramp capacitor 11.

A capacitance of the accumulation capacitor 2 is significantly larger, in particular at least 100 times larger, than a capacitance of the capacitive sensor element 1.

The charging voltage source 3 is configured to generate a saw-tooth-formed charging voltage VC, see Fig. 2, for charging the capacitive sensor element 1.

The switching state of the charge transfer transistor 4 is controlled by the level of the charging voltage VC.

Referring to Fig. 2, the saw-tooth-formed charging voltage VC has: a rising slope RS having a duration between 0,001 ms and 10 ms, wherein a voltage difference between the start of the rising slope RS and the end of the rising slope RS is in a range between 3 V and 48 V, a plateau PT having a duration between 0,001 ms and 1 ms, and a falling slope FS having a duration between 1 ns and 10 µs. The voltage VA across the accumulation capacitor 2 is depicted above the charging voltage VC due to illustration purposes. Self-evidently this does not mean that the level of the voltage VA across the accumulation capacitor 2 is higher than the level of the charging voltage VC. A voltage delta of the charging voltage VC may e.g. be approximately 15 V, wherein a voltage delta of the voltage VA across the accumulation capacitor 2 may e.g. be approximately 25 mV.

The capacitive sensor element 1 represents the main sensing target, for instance, a touch pad where a user presses on a PCB (Printed Circuit Board). The components 14, 18, 19, 20, 21, and 22 are the components of a current source. In conjunction with the components 11, 15, 16 and 17 a saw tooth waveform is generated.

At every falling edge of the charging voltage VC, the charge transfer transistor 4 is momentarily forward bias such that the electric charge accumulated in the capacitive sensor element 1 is transferred from the charge transfer transistors 4 emitter to the charge transfer transistors 4 collector. After the second diode 8, the electric charge is now stored in the accumulation capacitor 2 and can be analog-digital-converted and then be processed in the actuation detection device 5.

Choosing appropriate values of the components and of the frequency and of the duty-cycle of the pulse shaped voltage generated by the voltage source 15, a very sensitive response to small changes in the capacitance of the capacitive sensor element 1 can be achieved. Further, a very linear relationship exits between the capacitance of the capacitive sensor element 1 and the voltage Va.

## Claims

1. Capacitive touch sensor circuit (100), comprising:
- a capacitive sensor element (1), wherein a capacitance of the capacitive sensor element (1) depends on the actuation state of the capacitive sensor element (1),
- an accumulation capacitor (2),
- a charging voltage source (3) being configured to generate a charging voltage (VC) for charging the capacitive sensor element (1),
- a charge transfer transistor (4) being configured to transfer electrical charge from the charged capacitive sensor element (1) to the accumulation capacitor (2), and
- an actuation detection device (5) being configured to measure a voltage (VA) across the accumulation capacitor (2) to detect if the capacitive sensor element (1) is actuated or not actuated,
**characterized in that**
- the charging voltage source (3) is configured to generate a saw-tooth-formed charging voltage (VC) for charging the capacitive sensor element (1).

2. Capacitive touch sensor circuit (100) according to claim 1, **characterized in that**
- the charge transfer transistor (4) is controlled by the charging voltage (VC).

3. Capacitive touch sensor circuit (100) according to any of the preceding claims, **characterized in that**
- the saw-tooth-formed charging voltage (VC) has:
- a rising slope (RS) having a duration between 0,001 ms and 10 ms, wherein a voltage difference between the start of the rising slope (RS) and the end of the rising slope (RS) is in a range between 3 V and 48 V,
- a plateau (PT) having a duration between 0,001 ms and 1 ms, and
- a falling slope (FS) having a duration between 1 ns and 10 µs.

4. Capacitive touch sensor circuit (100) according to any of the preceding claims, **characterized in that**
- the capacitive touch sensor circuit (100) comprises:
- a first diode (6) connected between the charging voltage (VC) and the emitter of the charge transfer transistor (4),
- wherein the capacitive sensor element (1) is connected between the emitter of the charge transfer transistor (4) and a reference potential (GND),
- a first resistor (7), wherein the first resistor (7) is connected in parallel to the capacitive sensor element (1),
- a second diode (8), wherein the second diode (8) is connected between the collector of the charge transfer transistor (4) and the accumulation capacitor (2), and
- wherein the accumulation capacitor (2) is connected between the cathode of the second diode (8) and the reference potential (GND).

5. Capacitive touch sensor circuit (100) according to claim 4, **characterized in that**
- the capacitive touch sensor circuit (100) comprises:
- a second resistor (9), wherein the second resistor (9) is connected in parallel to the accumulation capacitor (2), and
- a third resistor (10), wherein the third resistor (10) is connected between the charging voltage (VC) and the base of the charge transfer transistor (4).

6. Capacitive touch sensor circuit (100) according to claim 4 or 5, **characterized in that**
- the first diode (6) and the second diode (8) are Schottky diodes.

7. Capacitive touch sensor circuit (100) according to any of the preceding claims, **characterized in that**
- the charging voltage source (3) comprises:
- a ramp capacitor (11), wherein the potential difference across the ramp capacitor (11) corresponds to the charging voltage (VC),
- a current source (12) supplying a charging current to the ramp capacitor (11), and
- a discharging circuit (13) periodically discharging the ramp capacitor (11).

8. Capacitive touch sensor circuit (100) according to any of the preceding claims, **characterized in that**
- a capacitance of the accumulation capacitor (2) is significantly larger, in particular at least 100 times larger, than a capacitance of the capacitive sensor element (1).
